# EUROPÄISCHE PATENTSCHRIFT

(11) **EP 2 458 647 B1**
(45) Veröffentlichungstag und Bekanntmachung des Hinweises auf die Patenterteilung: **18.07.2018**
(21) Anmeldenummer: 11189600.7
(22) Anmeldetag: 17.11.2011
(51) Int. Cl.: H01L 31/05, H01L 31/02, H02G 13/00, H01R 4/44, H01R 4/64

(54) **Blitzschutz-, Erdungs- und Potentialausgleichsklemme**
Lightning protection, grounding and potential equalization connection terminal
Borne de connexion anti-foudre, de mise à la terre et de compensation de potentiel

(30) Priorität: 29.11.2010 DE 102010052824; 06.06.2011 DE 102011103415
(43) Veröffentlichungstag der Anmeldung: 30.05.2012
(73) Patentinhaber: Dehn + Söhne GmbH + Co. KG, 92318 Neumarkt/Opf. (DE)
(72) Erfinder: Duschek, Willibald, 92367 Pilsach (DE); Lang, Johanna, 92364 Deining (DE); Seger, Siegfried, 92364 Deining (DE); Müller, Klaus-Peter, 92369 Sengenthal (DE)
(74) Vertreter: Kruspig, Volkmar

(56) Entgegenhaltungen:
- AT-B- 390 854
- DE-U- 1 801 260
- DE-U1- 8 715 375
- DE-U1-202005 009 883

## Beschreibung

Die Erfindung betrifft eine Blitzschutz-, Erdungs- und Potentialausgleichsklemme, bestehend aus einem Überleger mit Ausformungen zur Aufnahme eines Leiterabschnitts gemäß Patentanspruch 1.

Als Tragkonstruktionen für Photovoltaikanlagen werden üblicherweise Aluminium-Strangprofile unterschiedlicher Querschnittsformen verwendet.

Zur Aufnahme von Verbindungselementen der einzelnen Modulträger oder Strangprofile und von Befestigungselementen für die Halterung von Photovoltaikmodulen besitzen die Profile spezielle durchgehende Seitenwände und schlitzförmige Aussparungen.

Photovoltaikmodule sind elektrische Betriebsmittel, welche aus Gründen des Personen- und Sachschutzes in den Potentialausgleich eines Gebäudes oder einer Anlage eingebunden werden müssen. Über solche Verbindungen wird auch ein Anschluss an die Erdungsanlage hergestellt. Ein solcher Anschluss bzw. eine derartige Verbindung ist notwendig für den Blitzschutz-Potentialausgleich, den Schutzpotentialausgleich sowie als Erdanschluss für einen Funktionspotentialausgleich.

Aus der DE 20 2005 009 883 U1 ist eine Klemme zur Befestigung und gleichzeitiger elektrischer Potentialanbindung von gerahmten Photovoltaikmodulen auf entsprechenden Schienenprofilen als Mittelhalterklemme vorbekannt. Eine dort vorgesehene Schenkelform, welche im Wesentlichen einem U-Profil entspricht, weist eine flächige Auflage auf einem Rahmenprofil auf. Bei einer Ausgestaltung der Lösung nach DE 20 2005 009 883 U1 sind Dornen in die Auflagefläche der Klemme zum Modulrahmen eingebracht, um eine elektrisch leitende Verbindung zwischen Modulrahmen und Schienenunterkonstruktion zu schaffen. Dies wird im Falle eines illustrierten Modulrahmens über die Durchdringung dieser nicht leitfähigen Metallschicht durch entsprechend hart ausgebildete vorerwähnte Edelstahldorne erreicht.

Bei der sogenannten TRIC-Potentialausgleichsklemme der Firma FR Frankensolar GmbH, Nürnberg, unter www.tric-montagesystem.de im Internet abrufbar, handelt es sich um eine Klemme, die einen Überleger mit Ausformung zur Aufnahme eines starren Leiterabschnitts aufweist. An die Ausformung schließt sich eine im Wesentlichen ebene Aufnahmefläche an. Weiterhin weist die vorbekannte Potentialausgleichsklemme eine Bohrung für eine Klemmenschraube oder einen Klemmenbolzen auf, wobei im Bereich der Bohrung eine Durchbunsung zur Schaffung einer Auflagefläche für ein Befestigungsmittel, insbesondere eine Mutter nebst Unterlegscheibe vorgesehen ist. Diese Klemme ist derart gestaltet, dass sie mit gebräuchlichen Befestigungsschrauben an einem entsprechenden Strangprofil fixiert werden kann, wobei zur Befestigung Hammerkopfschrauben, Halfenschrauben, Sechskantschrauben oder dergleichen Mittel eingesetzt werden können.

Die Ausformung des Überlegers der bekannten TRIC-Klemme umgreift einen entsprechenden starren Leiter und sorgt für dessen mechanische, aber auch elektrische Verbindung zum Aluminium-Strangprofil.

Es hat sich jedoch gezeigt, dass eine Klemme gemäß dem vorbekannten Stand der Technik bedingt durch die Ausgestaltung der Ausformung im Überleger nur für bestimmte Durchmesser entsprechender Leiter genutzt werden kann.

Aus der AT 390 854 B ist eine vollisolierte Abzweigklemme für isolierte Freileitungsleiter vorbekannt, die drei mittels Schrauben spannbare Klemmbacken aufweist, in denen in Klemmlängsrichtung angeordnete parallele Kanäle für den Haupt- und den Abzweigleiter ausgespart sind. Ein in der Abzweigklemme mit Zähnen versehenes Kontaktstück ist in der Lage, nach Durchstoßen der Leiterisolation eine elektrische Verbindung zwischen dem Haupt- und dem Abzweigleiter herzustellen. Das diesbezügliche Kontaktstück ist in etwa T-förmig ausgebildet und es tragen die Schenkel des Kontaktstücks die Zahnreihen zum Durchstoßen der Leiterisolation.

Aus dem deutschen Gebrauchsmuster DE 1 801 260 U ist ein Klemmstück zur Verbindung eines Blitzableiterdrahtes mit einer Erdeinführungsstange vorbekannt. Selbiges besteht aus einer zweiteiligen Klemmschelle mit zwischengelegtem Einlagestück, das beiderseits Auskehlungen besitzt.

Bei dem Gebrauchsmuster DE 87 15 375 U1 wird von einer Mehrzweck-Verbindungsklemme ausgegangen, welche zwei schalenartige Hälften mit durchgehender Sicke zum Einlegen eines Drahtes oder Leiters umfasst. Mindestens eine, bevorzugt jedoch beide der schalenartigen Hälften weisen im Abstand zu der jeweiligen erstgenannten Sicke eine weitere durchgehende Sicke auf, deren Querschnitt wesentlich kleiner als der Querschnitt der erstgenannten Sicke ist, wobei die Sicke größeren Querschnits und die Sicke kleineren Querschnitts einer Schalenhälfte sich auf der gleichen Schalenseite befinden.

Aus dem Vorgenannten ist es daher Aufgabe der Erfindung, eine weiterentwickelte Blitzschutz-, Erdungs- und Potentialausgleichsklemme, insbesondere für Photovoltaikanlagen, umfassend einen Überleger mit Ausformung zur Aufnahme eines Leiterabschnitts anzugeben, welche universell für verschiedenste Leiter oder Kabel nutzbar ist und die allen Anforderungen insbesondere hinsichtlich ausreichender Blitzstromtragfähigkeit genügt.

Die Lösung der Aufgabe der Erfindung erfolgt durch eine Blitzschutz-, Erdungs- und Potentialausgleichsklemme gemäß der Merkmalskombination nach Patentanspruch 1, wobei die Unteransprüche mindestens zweckmäßige Ausgestaltungen und Weiterbildungen umfassen.

Es wird demnach von einer Blitzschutz- und Potentialausgleichsklemme, insbesondere für Photovoltaikanlagen ausgegangen, welche aus einem Überleger mit Ausformung zur Aufnahme eines Leiterabschnitts besteht. Weiterhin weist die Klemme eine im Wesentlichen ebene Auflagefläche sowie mindestens eine Bohrung für eine Klemmenschraube oder einen Klemmenbolzen auf, wobei im Bereich der Bohrung eine Durchbunsung oder Prägung zur Schaffung einer Auflagefläche für ein Befestigungsmittel, insbesondere einer Mutter vorgesehen ist.

Erfindungsgemäß ist eine Kontaktplatte vorhanden, deren Ausdehnung bzw. lichte Abmessungen dem Überleger entsprechen.

Die Kontaktplatte weist an zwei gegenüberliegenden Seiten eine Aufkantung oder Abkantung auf, in welche der Überleger im Montagezustand eintaucht.

Weiterhin weist die Kontaktplatte eine Profilstruktur auf, welche in Richtung der Ausformung des Überlegers verläuft und sich zur Ausformung hin erstreckt. In der Kontaktplatte ist eine Ausnehmung befindlich, deren Lage im Wesentlichen zur Bohrung im Überleger kongruent ist, um die Klemmenschraube oder den Klemmenbolzen aufzunehmen.

Gemäß einer Ausführungsform der Erfindung besitzt die Ausformung eine erhabene Struktur und eine parallel zur Aufkantung verlaufende Sicke.

Bevorzugt ist die Kontaktplatte als Stanz-Biegeteil aus einem metallenen, insbesondere federelastischen Material gefertigt.

Bei einer Ausführungsform der Erfindung kann die Kontaktplatte kegelspitzenartige zur Ausformung und/oder zur Klemmenunterseite gerichtete Prägungen oder Vorsprünge besitzen, so dass sich der elektrische Übergangswiderstand sowohl zum Aluminium-Strangprofil als auch zum aufgenommenen Leiter reduziert und gleichzeitig eine sichere mechanische Verbindung gegeben ist.

Bei einer weiteren Ausgestaltung der Erfindung kann der Überleger als Mehrfachüberleger, insbesondere als Doppelüberleger mit zwei im Wesentlichen parallel verlaufenden Ausformungen ausgeführt werden.

Dabei besteht erfindungsgemäß die Möglichkeit, die Radien der Ausformungen gleich, aber auch unterschiedlich auszubilden, um eine möglichst große Varianz hinsichtlich der Aufnahme von elektrischen Leitern oder Kabeln mit unterschiedlichem Querschnitt zu schaffen.

Weiterhin ist ausgestaltend die Klemmenbreite gleich oder kleiner als die Breite eines insbesondere Solarkollektoren-Befestigungsprofils gewählt. Hierdurch wird ein unerwünschter Überstand der Klemme bezogen auf die maximale Breite des Befestigungsprofils vermieden.

Bei einer Ausführungsform der Erfindung entspricht der kleinste Abstand zwischen einer der Aufkantungen und der Profilstruktur mindestens der Materialdicke des Überlegers.

Bevorzugt weist die Profilstruktur einen M-förmigen Querschnitt auf, wobei im M-Zwickel Leiter auch kleineren Querschnitts bezogen auf den Radius der Ausformung im Überleger und/oder Litzenleiter fixierbar sind.

Die federelastischen Eigenschaften der Kontaktplatte gewährleisten ein blitzstromtragfähiges elektrisches Kontaktieren von flexiblen, insbesondere Litzenleitern, Seilen und/oder Leitern eines geringeren Querschnitts.

Zum Befestigen der erfindungsgemäßen Klemme auf der entsprechenden Befestigungsschiene bzw. dem derartig ausgebildeten Aluminium-Strangprofil muss zum Klemmen der anzuschließenden Leiter die entsprechende Klemmenschraube bzw. Mutter nur gelockert, jedoch nicht vollständig gelöst werden.

Die Größe der Kontaktplatte und auch des Überlegers ist so gewählt, dass zum einen eine flächige Auflage auf gängigen Profilgrößen gegeben ist und dass sowohl in Kreuz- als auch in Parallelanordnung genügend Kontaktfläche für den elektrischen Stromübergang zur Verfügung steht.

Die Geometrie der Kontaktplatte ist so gestaltet, dass in Kombination mit dem Doppelüberleger auf einer Seite des Doppelüberlegers kleinere Leitungsquerschnitte bis z.B. 2,5mm² ein- und mehrdrähtig geklemmt werden können und auf der anderen gegenüberliegenden Seite des Doppelüberlegers größere mehrdrähtige Seile und Rundleiter bis zu 10mm Durchmesser klemmbar sind.

Die erfindungsgemäße Klemme ist so ausgestaltet, dass es sowohl möglich ist, nur einen Leiter zu klemmen. Andererseits ist es aber auch möglich, eine parallele Klemmung von zwei Leitern, auch mit unterschiedlichen Querschnitten vorzunehmen.

Wie bereits erwähnt, ist die geometrische Form der Profilstruktur der Kontaktplatte so gewählt, dass speziell für kleinere Leitungsquerschnitte beim Klemmvorgang eine Federkraft aufgebaut wird, die für einen dauerhaften Anpressdruck sorgt und somit einen sicheren und alterungsstabilen Stromübergang gewährleistet.

Die Erfindung soll nachstehend anhand eines Ausführungsbeispiels sowie unter Zuhilfenahme von Figuren näher erläutert werden.

Hierbei zeigen:
- Fig. 1: eine perspektivische Darstellung einer kompletten Blitzschutz- und Potentialausgleichsklemme mit Hammerkopfschraube sowie Befestigungsmutter und
- Fig. 2a: bis 2e beispielhafte Klemmungen an einem Aluminium-Strangprofil.

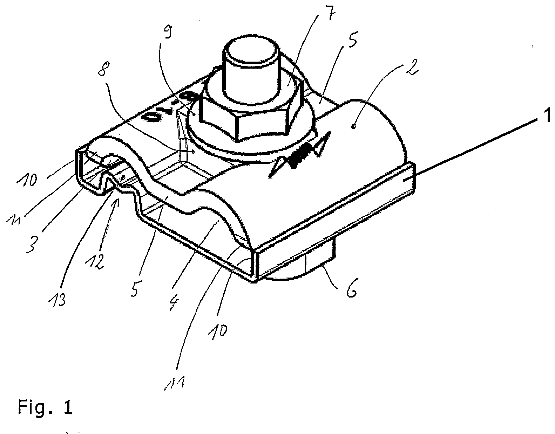

Die Darstellung nach Fig. 1 geht von einem Doppelüberleger 2 aus, welcher eine erste Ausformung 3 und eine zweite Ausformung 4 mit vorgegebenem Radius zeigt.

Die Ausformungen 3 und 4 dienen zur Aufnahme eines Leiterabschnitts eines elektrischen Leiters.

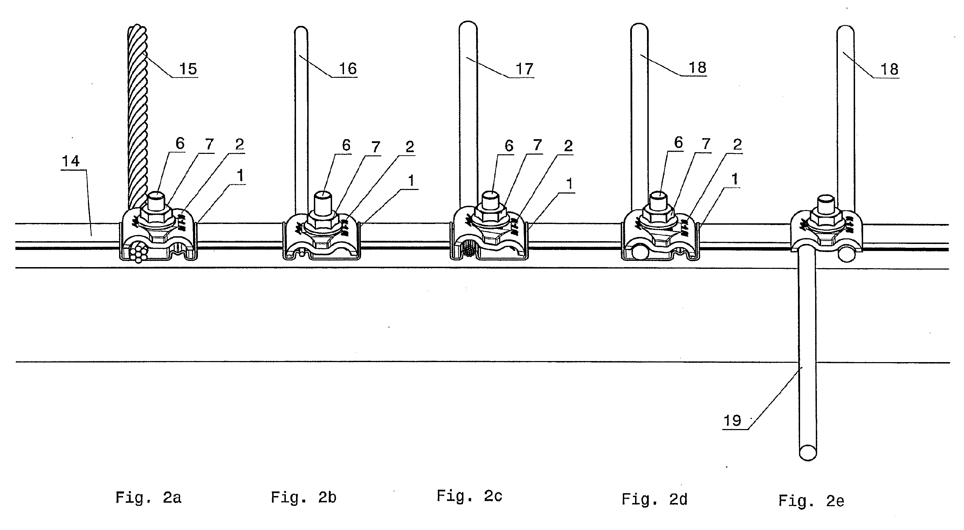

Zwischen den Ausformungen 3 und 4 befindet sich eine im Wesentlichen ebene Auflagefläche 5. Zwischen den beiden Bereichen der Auflagefläche 5 ist eine Bohrung vorhanden, die eine Klemmenschraube 6 aufnimmt. Die Klemmenschraube 6 ist mit einer Mutter 7 versehen, so dass sich die in den Fig. 2a bis 2e gezeigte Befestigungsmöglichkeit an einem Aluminiumprofil mit durchgehendem Befestigungsschlitz ergibt.

Im Bereich der Bohrung weist der Überleger 2 noch eine Durchbunsung 8 zur Schaffung einer Auflagefläche für die Befestigungsmutter 7 bzw. eine entsprechende Unterlegscheibe 9 auf.

Die erfindungsgemäße Kontaktplatte 1 besitzt lichte Abmessungen, die derjenigen des Überlegers 2 entsprechen.

Die Kontaktplatte weist darüber hinaus an zwei gegenüberliegenden Seiten eine Aufkantung 10 auf, in welche der Überleger 2 mit seinen Endabschnitten 11 am Rand der Ausformung 3; 4 eintaucht.

Weiterhin besitzt die Kontaktplatte 1 eine Profilstruktur 12, welche in Richtung der Ausformung 3 des Überlegers 2 verläuft und sich zur Ausformung 3 hin erstreckt.

Auch in der Kontaktplatte 1 ist eine Ausnehmung befindlich, deren Lage im Wesentlichen zur Bohrung im Überleger 2 kongruent ist (in der Fig. 1 nicht gezeigt).

Es ist aus der Fig. 1 ersichtlich, dass die Profilstruktur 12 erhaben ausgebildet ist sowie eine parallel zur Aufkantung 10 verlaufende Sicke 13 besitzt.

Die Kontaktplatte 1 ist bevorzugt als metallenes Stanz-Biegeteil mit federelastischen Eigenschaften realisierbar.

Ergänzend kann die Kontaktplatte 1 kegelspitzenartige zur Ausformung und/oder zur Klemmenunterseite gerichtete Prägungen und Vorsprünge besitzen (in den Figuren nicht gezeigt).

Die Ausformungen 3 und 4 im Überleger 2 verlaufen im Wesentlichen parallel, wobei beim gezeigten Beispiel die Radien der Ausformungen 3 und 4 gleich gewählt wurden.

Die Fig. 2a bis 2e machen deutlich, dass die Klemmenbreite gleich oder kleiner als die Breite des Befestigungsprofils 14 gewählt ist.

Aus der Betrachtung der Ansicht nach den Fig. 2a bis 2e kann entnommen werden, wie mit Hilfe der erfindungsgemäßen Klemme, umfassend den Überleger 2 und bei den Fig. 2a bis 2d die Kontaktplatte 1, unterschiedlichste Leiter elektrisch kontaktierbar sind.

Gemäß Fig. 2a ist ein Aluminiumseil 15 geklemmt.

Fig. 2b zeigt die Klemmung eines Eindrahtkupferleiters 16 (im Klemmbereich wurde die Isolation des Leiters 16 entfernt).

In der Darstellung nach Fig. 2b ist auch erkennbar, wie der abisolierte Teil des Kupferleiters 16 von der Profilstruktur der Kontaktplatte 1, die eine M-Form besitzt, aufgenommen wird.

Gleiches gilt für die Darstellung des Kupferlitzenleiters 17 nach Fig. 2c.

Die Kontaktierung eines starren Rundleiters 18 ist anhand der Fig. 2d nachvollziehbar.

Wenn lediglich quasi parallel verlaufenden Rundleiter 18 und 19 gemäß Fig. 2e kontaktiert werden, kann auf die Kontaktplatte 1 verzichtet werden.

Der M-förmige Querschnitt der Profilstruktur 12 der Kontaktplatte 1 ist insbesondere bei den Fig. 2a und 2d deutlich erkennbar.

## Patentansprüche

1. Blitzschutz-, Erdungs- und Potentialausgleichsklemme, bestehend aus einer Kontaktplatte (1) und aus einem Überleger mit Ausformungen zur Aufnahme eines Leiterabschnitts, wobei der Überleger als Doppelüberleger (2) mit zwei parallel verlaufenden Ausformungen (3; 4) ausgeführt ist, einer zwischen den Ausformungen gelegenen ersten ebenen Auflagefläche (5), die in zwei Bereiche aufgeteilt ist, mindestens einer Bohrung für eine Klemmenschraube (6) oder einen Klemmenbolzen, wobei die Bohrung zwischen den beiden Bereichen der ersten Auflagefläche gelegen ist, wobei im Bereich der Bohrung eine Durchbunsung (8) zur Schaffung einer zweiten Auflagefläche für eine Befestigungsmutter (7) vorgesehen ist, wobei die zweite Auflagefläche in Richtung der Ausformungen höher gelegen ist als die erste Auflagefläche, wobei die Kontaktplatte (1), deren lichte Abmessungen dem Überleger (2) entsprechen, an zwei gegenüberliegenden Seiten eine Aufkantung (10) besitzt, in welche der Überleger (2) im Montagezustand eintaucht, wobei die Kontaktplatte (1) eine Profilstruktur (12) aufweist, welche in Richtung (3) einer der beiden Ausformungen des Überlegers verläuft und sich zur besagten einen Ausformung (3) erstreckt und wobei in der Kontaktplatte (1) eine Ausnehmung befindlich ist, deren Lage zur Bohrung im Überleger (2) kongruent ist.

2. Blitzschutz-, Erdungs- und Potentialausgleichsklemme nach Anspruch 1,
**dadurch gekennzeichnet, dass**
die Profilstruktur (12) erhaben ausgeführt ist sowie eine parallel zur Aufkantung (12) verlaufende Sicke (13) besitzt.

3. Blitzschutz-, Erdungs- und Potentialausgleichsklemme nach Anspruch 1 oder 2,
**dadurch gekennzeichnet, dass**
die Kontaktplatte (1) als Stanz-Biegeteil, Fräs- oder Spritzgussteil gefertigt ist und federnde Eigenschaften aufweist.

4. Blitzschutz-, Erdungs- und Potentialausgleichsklemme nach einem der vorangegangenen Ansprüche,
**dadurch gekennzeichnet, dass**
die Kontaktplatte (1) kegelspitzenartige, zur Ausformung und/oder zur Klemmenunterseite gerichtete Prägungen oder Vorsprünge besitzt.

5. Blitzschutz-, Erdungs- und Potentialausgleichsklemme nach einem der vorangegangenen Ansprüche,
**dadurch gekennzeichnet, dass**
der kleinste Abstand zwischen einer der Aufkantungen (10) und der Profilstruktur (12) mindestens der Materialdicke des Überlegers (2) entspricht.

6. Blitzschutz-, Erdungs- und Potentialausgleichsklemme nach einem der vorangegangenen Ansprüche,
**dadurch gekennzeichnet, dass**
die Profilstruktur (12) einen M-förmigen Querschnitt aufweist.

## Claims

1. Lightning protection, grounding and equipotential bonding terminal consisting of a contact plate (1) and of
a cleat with formations for receiving a conductor portion, wherein the cleat is designed as a double cleat (2) with two parallel formations (3; 4), a first flat support surface (5) located between the formations, which is divided into two portions, at least one bore for a clamping screw (6) or a clamping bolt, the bore being located between the two portions of the first support surface, wherein an embossing (8) is provided in the portion of the bore for generating a second support surface for a fastening nut (7), the second support surface being located higher in the direction of the formations than the first support surface; wherein the contact plate (1),
whose inside dimensions correspond to the cleat (2), has raised edges (10) on two opposite sides, into which the cleat (2) immerses in the assembled state, wherein the contact plate (1) comprises a profile structure(12) which extends in the direction (3) of one of the two formations of the cleat and extends to said one formation (3), and wherein there is a recess in the contact plate, the position of which is congruent to the bore in the cleat.

2. Lightning protection, grounding and equipotential bonding terminal according to Claim 1,**characterized in that**
the profile structure (12) is adapted embossed having a bead extending parallel to the raised edge (12).

3. Lightning protection, grounding and equipotential bonding terminal according to Claim 1 or 2, **characterized in that**
the contact plate (1) is manufactured as a stamped-bent part, milled or injection molded part and comprises springy properties.

4. Lightning protection, grounding and equipotential bonding terminal according to one of the preceding claims, **characterized in that**
the contact plate (1) has conical-tip embossings and projections directed towards the formation and/or the underside of the clamp.

5. Lightning protection, grounding and equipotential bonding terminal according to one of the preceding claims, **characterized in that**
the smallest distance between one of the raised edges (10) and the profile structure (12) at least corresponds to the material thickness of the cleat (2).

6. Lightning protection, grounding and equipotential bonding terminal according to one of the preceding claims, **characterized in that**
the profile structure (12) comprises a M-shaped cross section.

## Revendications

1. Borne de protection anti-foudre, de mise à la terre et de compensation de potentiel, constituée par une plaque de contact (1) et par un élément de superposition pourvu de conformations pour loger une portion de conducteur, l'élément de superposition étant réalisé sous forme d'élément double de superposition (2) ayant deux conformations parallèles (3 ; 4), une première surface d'appui plane (5) située entre les conformations et subdivisée en deux zones, au moins un perçage pour une vis de borne (6) ou un boulon de borne,
dans laquelle
le perçage est situé entre les deux zones de la première surface d'appui, et au niveau du perçage il est prévu une barrette (8) pour réaliser une seconde surface d'appui pour un écrou de fixation (7),
la seconde surface d'appui est située plus haut en direction des conformations que la première surface d'appui,
la plaque de contact (1) dont les dimensions libres correspondent à celles de l'élément de superposition (2) possède sur deux faces opposées un rebord (10) dans lequel l'élément de superposition (2) plonge à l'état monté, la plaque de contact (1) présente une structure profilée (12) qui s'étend dans la direction (3) de l'une des deux conformations de l'élément de superposition et s'étend vers ladite conformation (3),
dans la plaque de contact (1) se situe un évidement dont la position est congruente par rapport au perçage dans l'élément de superposition (2).

2. Borne de protection anti-foudre, de mise à la terre et de compensation de potentiel selon la revendication 1,
**caractérisée en ce que**
la structure profilée (12) est réalisée de façon surélevée et possède une moulure (13) parallèle au rebord (12).

3. Borne de protection anti-foudre, de mise à la terre et de compensation de potentiel selon la revendication 1 ou 2,
**caractérisée en ce que**
la plaque de contact (1) est fabriquée sous forme de pièce poinçonnée cintrée, de pièce fraisée ou de pièce coulée par injection et présente des propriétés élastiques.

4. Borne de protection anti-foudre, de mise à la terre et de compensation de potentiel selon l'une des revendications précédentes,
**caractérisée en ce que**
la plaque de contact (1) possède des empreintes ou saillies en forme de pointes de cône dirigées vers la conformation et/ou vers la face inférieure de borne.

5. Borne de protection anti-foudre, de mise à la terre et de compensation de potentiel selon l'une des revendications précédentes,
**caractérisée en ce que**
la plus petite distance entre l'un des rebords (10) et la structure profilée (12) correspond au moins à l'épaisseur de matériau de l'élément de superposition (2).

6. Borne de protection anti-foudre, de mise à la terre et de compensation de potentiel selon l'une des revendications précédentes,
**caractérisée en ce que**
la structure profilée (12) présente une section transversale en forme de M.
